Europäisches Patentamt

European Patent Office

Office européen des brevets

(19)

(11) Numéro de publication : **0 237 371 B1**

(12) **FASCICULE DE BREVET EUROPEEN**

(45) Date de publication du fascicule du brevet :
10.04.91 Bulletin 91/15

(51) Int. Cl.⁵ : **H05B 3/06**

(21) Numéro de dépôt : **87400215.7**

(22) Date de dépôt : **30.01.87**

(54) **Procédé pour la réalisation de connexions électriques entre des bandes conductrices minces, bandes conductrices pourvues de moyens de connexion réalisés par ledit procédé et dispositif obtenu.**

(30) Priorité : 06.02.86 FR 8601625

(43) Date de publication de la demande :
16.09.87 Bulletin 87/38

(45) Mention de la délivrance du brevet :
10.04.91 Bulletin 91/15

(84) Etats contractants désignés :
BE CH DE ES GB LI

(56) Documents cités :
EP-A- 0 005 020
FR-A- 2 023 172
FR-A- 2 472 856
US-A- 3 124 641
US-A- 3 263 015
US-A- 3 872 281
US-A- 3 996 447
US-A- 4 314 095

(73) Titulaire : **AEROSPATIALE Société Nationale Industrielle**
**37, Boulevard de Montmorency**
**F-75781 Paris Cédex 16 (FR)**

(72) Inventeur : **Camps, Guy**
**Parc de Ranguin 2 Bat.3**
**F-06150 Cannes La Bocca (FR)**
Inventeur : **Collard, Michel**
**Cédex 114§6, Chemin du Puits**
**F-06330 Roquefort Les Pins (FR)**

(74) Mandataire : **Bonnetat, Christian et al**
**CABINET BONNETAT 23, Rue de Léningrad**
**F-75008 Paris (FR)**

## Description

L'invention concerne un procédé pour la réalisation de connexions. électriques entre des bandes conductrices minces, les bandes conductrices pourvues de moyens de connexion et un dispositif obtenu selon la mise en oeuvre du procédé.

On connaît déjà des procédés pour la réalisation de connexions électriques entre des bandes conductrices minces qui sont utilisées notamment pour la conception de dispositifs de chauffage de surfaces.

En effet, les bandes conductrices, alimentées par une source électrique, engendrent alors de la chaleur chauffant les surfaces sur lesquelles elles sont appliquées.

On connaît, notamment par le brevet français 1 189 552 un procédé de fabrication d'éléments pour le chauffage électrique de surfaces, dans lequel on applique sur les surfaces à chauffer, une couche non conductrice revêtue sur une face d'une bande métallique, on colle la couche non conductrice au moyen d'un adhésif sur les surfaces à chauffer, et on recouvre l'autre face de la bande métallique d'une couche isolante. Les connexions électriques entre les bandes métalliques sont réalisées par des éléments de cuivre, soudés à l'étain aux extrémités des bandes métalliques. Plus précisément, un élément de cuivre relie transversalement une extrémité d'une première bande à une extrémité d'une seconde bande, par soudure. Pour réaliser cette connexion, il est nécessaire, dans ce brevet, que les deux bandes soient parallèles et que les extrémités des bandes soient sensiblement dans un même plan. Cette réalisation entraîne, en conséquence, des inconvénients dus à la disposition particulière obligatoire des bandes à relier, ce qui limite les possibilités de recouvrement des surfaces à chauffer, et ne permet pas un recouvrement optimal et homogène de celles-ci. Le chauffage des surfaces n'est alors pas homogène.

De plus, un autre inconvénient de ce procédé, réside dans l'opération de soudage proprement dite, qui est effectuée directement entre les bandes métalliques de faible épaisseur et l'élément unique de liaison entre ces bandes. La soudure effectuée, de par la température atteinte, risque d'endommager les bandes métalliques, voire de les détruire, notamment dans le cas où le matériau desdites bandes a un bas point de fusion.

La présente invention a pour but de pallier les inconvénients mentionnés ci-dessus et concerne un procédé pour la réalisation de connexions électriques, simple et peu coûteux, permettant de relier des bandes conductrices minces et souples, en évitant notamment les risques de détérioration de celles-ci et permettant toute position relative des bandes reliées.

La présente invention a pour but également d'obtenir un recouvrement optimal des surfaces, planes ou non, à chauffer.

La présente invention vise aussi les bandes conductrices pourvues de moyens de connexions réalisés par ledit procédé.

Un autre but de l'invention est de proposer un dispositif de chauffage de surfaces applicables, par exemple, dans les industries aéronautiques et aérospatiales.

A cet effet, selon l'invention, le procédé pour la réalisation de connexions électriques entre des bandes conductrices minces et souples, est caractérisé en ce que :

– dans une première phase, on fixe au moins une lamelle conductrice transversalement sur chacune desdites bandes, en

- disposant ladite lamelle, dont la longueur est supérieure à la largeur de ladite bande, sur l'une des faces de ladite bande ;
- repliant les extrémités débordantes de ladite lamelle sur l'autre face de ladite bande, tout en préformant lesdites lamelles, de façon à réaliser au moins partiellement au moins une boucle apte à recevoir une extrémité dénudée d'un conducteur électrique ; et
- rendant ladite lamelle enserrant la bande solidaire de ladite bande en liant mécaniquement les extrémités débordantes de ladite lamelle avec la partie de celle-ci disposée du côté opposé de ladite bande ;

– puis, dans une seconde phase, on relie entre elles, au moyen d'au moins un conducteur électrique lesdites lamelles desdites bandes, en

- disposant une extrémité dénudée d'un tel conducteur électrique dans une boucle de la lamelle solidaire de la première bande ;
- rendant l'extrémité dénudée dudit conducteur solidaire de ladite lamelle ;
- disposant l'autre extrémité dénudée dudit conducteur électrique dans une boucle de ladite lamelle solidaire de l'autre bande ; et
- rendant l'autre extrémité dénudée dudit conducteur solidaire de ladite lamelle.

On remarquera que les documents EP-A-0005020 et FR-A-2 472 856 décrivent des procédés pour la réalisation de connexions électriques entre une bande mince et souple et un conducteur, où l'on fixe une lamelle conductrice transversalement sur la bande et où le conducteur électrique est relié à ladite lamelle. Cependant, ces documents antérieurs concernant des domaines différents de celui de la présente invention.

Dans un mode de réalisation préféré de l'invention, on utilise des bandes conductrices métalliques recouvertes sur leurs faces d'une pellicule isolante adhésive et le dispositif est caractérisé en ce que :

– on sépare partiellement les deux dites pellicules isolantes adhésives de chacune desdites bandes ;

– on fixe une lamelle conductrice transversalement à une extrémité de chacune desdites bandes ;

– on relie, au moyen d'un conducteur électrique, ladite lamelle de la première bande avec ladite lamelle de la seconde bande ;

– on recouvre chacune des lamelles conductrices transversalement par la partie de la pellicule isolante adhésive séparée de sa bande conductrice.

De préférence, on utilise des bandes métalliques réalisées à partir d'un alliage de nickel et de chrome ayant de bonnes caractéristiques de conductivité électrique.

Avantageusement, on utilise des pellicules isolantes réalisées à partir d'un polyimide souple enduit sur l'une de ses faces d'un adhésif du type acrylique.

L'invention concerne de plus, une bande conductrice mince et souple recouverte sur chacune de ses faces, d'une pellicule isolante et caractérisée en ce qu'elle comporte au moins une lamelle conductrice disposée selon l'une quelconque des revendications du procédé, ladite lamelle étant apte à recevoir une extrémité d'un conducteur électrique.

Cette bande peut comporter un ruban adhésif appliqué par l'une de ses faces sur l'une desdites pellicules isolantes et une pluralité d'orifices traversent l'ensemble constitué par ladite bande métallique revêtue desdites pellicules isolantes et dudit ruban adhésif.

L'invention concerne de plus un dispositif de chauffage d'une surface comportant une pluralité de bandes conductrices métalliques revêtues, associées les unes aux autres au moyen de conducteurs électriques et alimentées par une source de courant.

Les figures du dessin annexé feront bien comprendre comment l'invention peut être réalisée. Des références identiques désignent des éléments semblables.

– Les figures 1A, 1B, 1C, 1D, 1E, 1F, 1G représentent les différentes phases du procédé selon l'invention.

– La figure 1H est une vue selon la flèche F de la figure 1D.

– La figure 2 représente, en perspective partiellement écorchée, une bande conductrice sur laquelle le procédé a été mis en oeuvre.

– La figure 3 représente une application dudit procédé à un dispositif de chauffage de surfaces.

La figure 1A montre partiellement, deux bandes conductrices, minces et souples, 1 et 1-1, dont l'épaisseur a été amplifiée et qui sont destinées à être reliées l'une à l'autre par la mise en oeuvre du procédé conforme à l'invention.

Quoique ces deux bandes 1 et 1-1 aient été disposées en regard l'une de l'autre par leur extrémité respective 3 et 3-1, il va de soi que leur disposition pourrait être tout à fait différente, par exemple perpendiculaire, oblique, parallèle, dans des plans différents etc... De même, leurs dimensions pourraient être différentes.

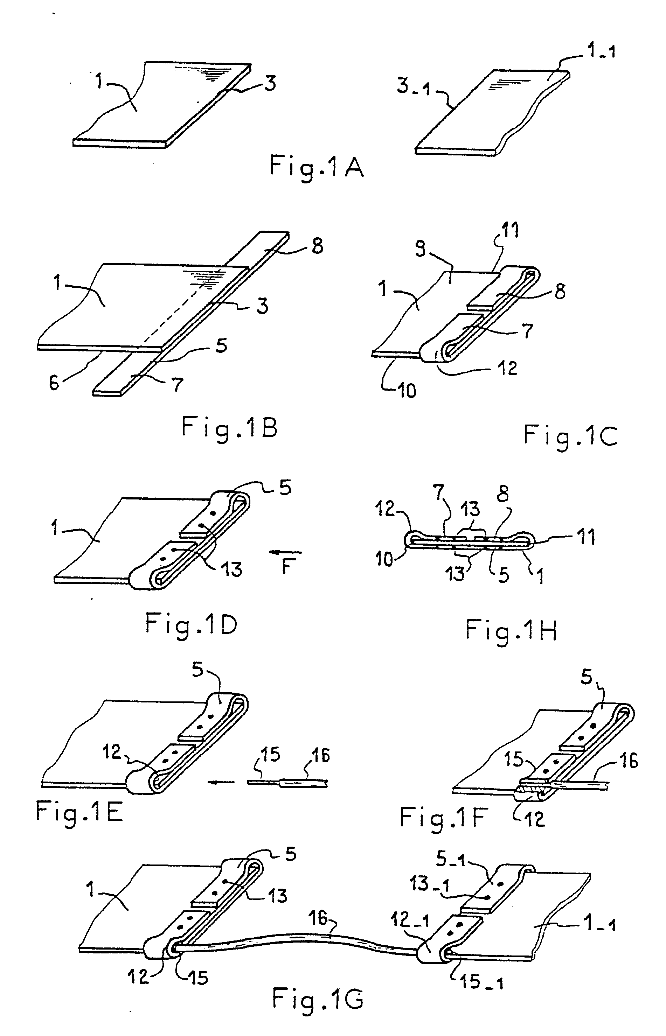

Sur les figures 1B à 1F, il n'a été illustré qu'une seule bande, en l'occurrence la bande 1, mais on précise que les opérations suivantes s'appliquent également à la bande 1-1. La première phase consiste à fixer une lamelle conductrice à au moins une des extrémités de chacune des bandes. Pour cela, (voir les figures 1B et 1C),on dispose une lamelle conductrice 9 sur une face 6 de la bande 1, de préférence perpendiculairement à son extrémité 3. On replie les deux extrémités 7 et 8 débordantes de la lamelle 5 sur l'autre face 9 de la bande.

La nature du matériau de la lamelle, par exemple, métallique comme la bande 1, permet de réaliser le repliage sans difficulté.

Ainsi, avantageusement, lors du repliage des deux extrémités 7 et 8 débordantes de la lamelle 5 sur la face 9 de la bande 1, on préforme les zones de la lamelle qui se trouvent sensiblement à proximité des bords latéraux 10 et 11 de la bande, de manière à réaliser au moins une boucle 12. Sur la figure 1D, à laquelle a été adjointe une figure 1H suivant la flèche F de la figure 1D, on solidarise la lamelle 5 de la bande 1 en pratiquant par exemple, des points de soudure 13 effectués à l'aide d'un appareil à souder non représenté sur les figures.

On obtient ainsi une liaison coeur-à-coeur de la lamelle avec la bande en évitant de souder directement sur la bande, ce qui permet ainsi de préserver les caractéristiques dimensionnelles et mécaniques de la bande 1.

Sur la figure 1E, on débute la seconde phase qui consiste à relier au moyen d'au moins un conducteur électrique 1 ; lamelle de la première bande 1 avec la lamelle de 1 ; seconde bande 1-1.

Pour cela, on présente une extrémité dénudée 15 d'un conducteur électrique 16 en regard de l'extrémité 3 de la bande 1 comportant la lamelle 5. On introduit, (figure 1F), l'extrémité 15 du conducteur dans la boucle 12 prévue pour la recevoir et on solidarise l'extrémité 3 de la boucle 12 de la lamelle, en pratiquant par exemple une soudure.

La figure 1G représente, une fois terminée, l'opération qui consiste à introduire l'autre extrémité 15-1 du conducteur 16 dans la boucle 12-1 préformée lors du repliage des extrémités débordantes de la lamelle 5-1 sur la bande 1-1.

La connexion électrique entre les bandes 1 et 1-1 est alors réalisée.

La liaison de la lamelle avec la bande pourrait être également obtenue par sertissage, rivetage ou tout autre moyen permettant d'assurer correctement leur assemblage. De même, on pourrait également concevoir de solidariser directement l'extrémité dénudée du conducteur sur la face extérieure de la lamelle.

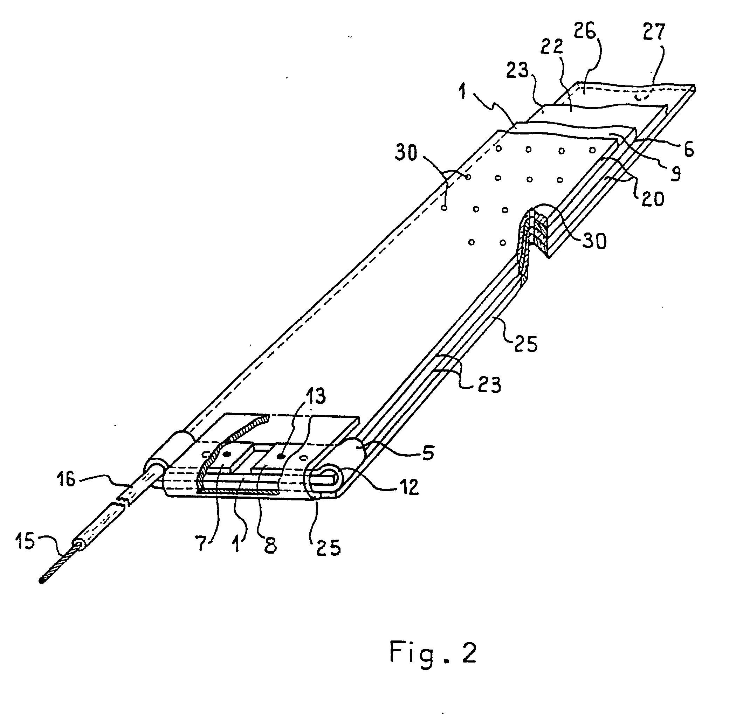

La figure 2 montre une bande conductrice sur laquelle a été mis en oeuvre le procédé ci-dessus décrit.

La bande conductrice, souple et mince 1 est réalisée dans un alliage de nickel et de chrome définissant ainsi la partie résistive et chauffante du produit.

Les deux faces 6 et 9 de la bande métallique sont revêtues chacune d'une pellicule isolante 20 réalisée dans un polyimide ayant de bonnes caractéristiques d'émissivité.

La face 22 de chaque pellicule isolante 20, qui vient en contact des faces 6 et 9 de la bande 1, est enduite d'une couche adhésive 23, ce qui assure l'adhérence de la pellicule sur la bande. La bande 1, de dimensions quelconques, est ainsi totalement enveloppée par les deux pellicules et parfaitement isolée (la largeur des pellicules est plus grande que la largeur de la bande).

La réalisation de la connexion électrique entre, par exemple, deux bandes conductrices ci-dessus décrites, s'effectue selon le procédé de l'invention.

Au préalable, on sépare sur une longueur suffisante les deux pellicules isolantes 20 de chaque bande métallique conductrice 1. Ensuite, dans la première phase du procédé, on fixe la lamelle 5 conductrice transversalement à l'extrémité 3 de chacune des bandes, et dans la seconde phase, on relie au moyen d'un conducteur électrique 16 la lamelle 5 de la première bande 1 avec la lamelle 5-1 de la seconde bande 1-1.

On recouvre les faces 6 et 9 de chaque bande munie de sa lamelle respective, des pellicules isolantes 20 adhésives, qui peuvent ou non recouvrir les lamelles. On dispose alors un ruban 25 adhésif sur ses deux faces 26, 27. Plus précisément, on applique la face adhésive 26 du ruban 25, par exemple sur l'une des pellicules isolantes 20 en enveloppant partiellement la lamelle 5 comme illustrée sur la figure 2.

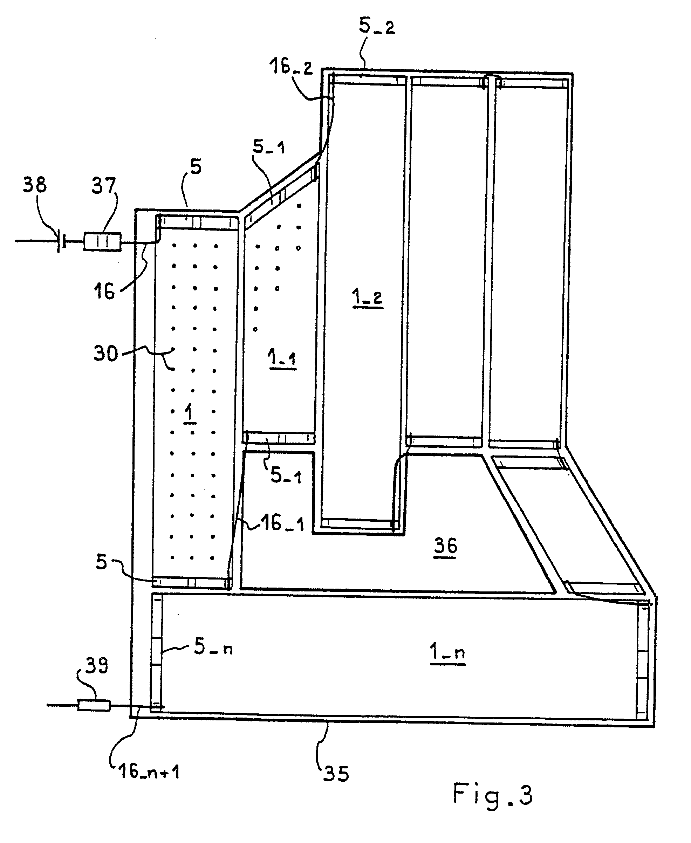

L'autre face adhésive 27 du ruban 25 est apte à être appliquée sur une surface à chauffer, comme il sera explicité en référence à la figure 3.

On peut également, dans une application particulière comme celle décrite en regard de la figure 3, pratiquer une pluralité d'orifices 30 traversant sensiblement perpendiculairement l'ensemble constitué de la bande conductrice métallique 1 enserrée des deux pellicules isolantes 20, dont une est revêtue du ruban adhésif 25.

La figure 3 montre un dispositif de chauffage comportant une pluralité de bandes conductrices minces et souples, associées les unes aux autres par la mise en oeuvre du procédé selon l'invention et qui permet de chauffer ainsi, une surface quelconque, plane ou non, sur laquelle sont disposées ces bandes.

Une application particulière du dispositif concerne les essais au sol des satellites artificiels. On sait en effet que, une fois sur leur orbite, les satellites sont soumis à des variations de températures importantes. En effet, la face d'un satellite tournée vers le soleil est portée à une température élevée, tandis que la face opposée du satellite, a une température très inférieure.

Il est donc intéressant de pouvoir recréer ces conditions, lors d'essais de simulation au sol, afin d'étudier et d'analyser le comportement du satellite soumis à ces variations de température sur son orbite. Avantageusement, selon l'invention, avant l'introduction du satellite dans un caisson sous vide de simulation, on dispose sur ces surfaces, des bandes conductrices, minces et souples, reliées entre elles par la mise en oeuvre du procédé.

A cet effet, il a été représenté, schématiquement, une surface 35 de forme quelconque d'un satellite, laquelle comporte une cavité 36. Les avantages obtenus selon le procédé sont alors évidents. En effet, la surface 35 est pratiquement recouverte, les jeux entre les diverses bandes étant de l'ordre du millimètre, et, la température que l'on souhaite obtenir sur la surface à chauffer est homogène en tout point de celle-ci.

Le dispositif comporte une première bande 1 munie d'une lamelle 5 sur laquelle est soudée un conducteur électrique 16 issu d'un connecteur 37 relié à une alimentation électrique 38. Les bandes sont appliquées directement sur la surface 35 grâce à la face adhésive 27 du ruban 25. Dans ce type d'application, les orifices 30 pratiqués dans les bandes, mentionnés précédemment, servent à l'évacuation des produits gazeux émis par l'adhésif, lorsqu'il se trouve dans un milieu extérieur tel que le vide. Ainsi, les orifices 30 évitent la formation de bulles qui risqueraient de cloquer les faces des bandes, compromettant alors l'homogénéité du chauffage de la surface 35.

La bande 1 est reliée, par une seconde lamelle 5 disposée à l'autre extrémité de la bande, a une lamelle 5-1 d'une seconde bande 1-1 par l'intermédiaire d'un autre conducteur 16-1.

De même, une seconde lamelle 5-1, disposée obliquement à l'autre extrémité de la bande 1-1, est reliée à une lamelle 5-2 d'une troisième bande 1-2 par un conducteur électrique 16-2 et ainsi de suite jusqu'à la dernière bande 1-n, par exemple plus large que les précédentes, dont la lamelle 5-n est reliée à un connecteur 39 au moyen d'un conducteur 16-n + 1.

Ainsi, lorsque l'alimenlation électrique 38 est branchée, les bandes conductrices, sous l'effet du courant qui les traversent, engendrent de la chaleur sur la surface 35. De par la disposition des bandes recouvrant la totalité de la surface, cette dernière acquiert une température identique en tout point, recréant les conditions réelles de température affectant le satellite.

Dans une variante de réalisation, on pourrait agencer les connexions électriques entre les diverses bandes conductrices en parallèle et/ou en série suivant le type d'application souhaité.

A titre indicatif, l'épaisseur d'une bande revêtue des pellicules isolantes et du ruban adhésif ne dépasse pas 0,5 millimètre.

## Revendications

1. Procédé pour la réalisation de connexions électriques entre des bandes conductrices (1, 1-1,...), minces et souples, caractérisé en ce que :
 – dans une première phase, on fixe au moins une lamelle (5, 5-1,...) conductrice transversalement sur chacune desdites bandes (1, 1-1,...), en
 • disposant ladite lamelle (5), dont la longueur est supérieure à la largeur de ladite bande, sur l'une (6) des faces de ladite bande (1) ;
 • repliant les extrémités (7, 8) débordantes de ladite lamelle (5) sur l'autre face (9) de ladite bande, tout en préformant lesdites lamelles, de façon à réaliser au moins partiellement au moins une boucle (12) apte à recevoir une extrémité dénudée (15) d'un conducteur électrique (16, 16-1,...) ; et
 • rendant ladite lamelle (5) enserrant la bande (1) solidaire de ladite bande (1) en liant mécaniquement les extrémités (7, 8) débordantes de ladite lamelle (5) avec la partie de celle-ci disposée du côté opposé (6) de ladite bande (1) ;
 – puis, dans une seconde phase, on relie entre elles, au moyen d'au moins un conducteur électrique (16, 16-1,...), lesdites lamelles desdites bandes, en
 • disposant une extrémité dénudée (15) d'un tel conducteur électrique (16) dans une boucle (12) de la lamelle (5) solidaire de la première bande (1) ;
 • rendant l'extrémité dénudée (15) dudit conducteur solidaire de ladite lamelle (5) ;
 • disposant l'autre extrémité dénudée (15-1) dudit conducteur électrique (16) dans une boucle (12) de ladite lamelle (5-1) solidaire de l'autre bande (1-1) ; et
 • rendant l'autre extrémité dénudée (15-1) dudit conducteur solidaire de ladite lamelle (5-1).

2. Procédé selon la revendication 1 dans lequel on utilise des bandes conductrices métalliques recouvertes sur leurs faces (9, 10) d'une pellicule isolante adhésive (20), caractérisé en ce que :
 – on sépare partiellement les deux dites pellicules isolantes (20) adhésives de chacune desdites bandes ;
 – on fixe une lamelle conductrice (5) transversalement à une extrémité (3) de chacune desdites bandes ;
 – on relie, au moyen d'un conducteur électrique (16) ladite lamelle de la première bande avec ladite lamelle de la seconde bande ;
 – on recouvre chacune des lamelles conductrices transversales (5) par la partie de la pellicule isolante adhésive (20) séparée de sa bande conductrice (1).

3. Procédé selon l'une des revendications 1 ou 2, caractérisé en ce qu'on utilise des bandes métalliques (1, 1-1,...) réalisées à partir d'un alliage de nickel et de chrome.

4. Procédé selon l'une des revendications 1 à 3, caractérisé en ce qu'on utilise des pellicules isolantes (20) réalisées à partir d'un polyimide souple enduit sur l'une de ses faces (22) d'un adhésif (23) du type acrylique.

5. Bande conductrice mince et souple recouverte sur chacune de ses faces (6, 9), d'une pellicule isolante (20), caractérisée en ce qu'elle comporte au moins une lamelle conductrice (5) disposée selon l'une quelconque des revendications du procédé, ladite lamelle étant apte à recevoir une extrémité d'un conducteur électrique (16).

6. Bande conductrice selon la revendication 5, caractérisée en ce qu'elle comporte un ruban adhésif (25) appliqué par l'une de ses faces sur l'une desdites pellicules (20) isolantes et en ce qu'une pluralité d'orifices (30) traversent l'ensemble constitué par ladite bande métallique (1) revêtue desdites pellicules isolantes (20) et dudit ruban adhésif (25).

7. Dispositif de chauffage d'une surface, caractérisé en ce qu'il comprend une pluralité de bandes (1, 1-1, 1-2...) conductrices reliées les unes aux autres conformément à l'une quelconque des revendications 1 à 5 au moyen de conducteurs électriques (16, 16-1...) et alimentées par une source de courant (38).

## Ansprüche

1. Herstellungsverfahren für elektrische Verbindungen zwischen dünnen und geschmeidigen leitenden Bändern (1, 1-1,...), dadurch **gekennzeichnet**, daß
 – in einer erten Phase auf jedem Band (1, 1-1,...) zumindest ein leitender Streifen (5,5-1,....) transversal festgelegt wird, indem
 • der Streifen (5), der eine größere Länge als die Breite des Bandes hat, auf eine (6) der Flächen des Bandes (1) angeordnet wird,
 • die über den Streifen (5) hinausgehenden Enden (7, 8) auf die andere Fläche (9) des Bandes umgelegt werden und die Streifen hierbei derart vorgeformt werden, daß zumindest teilweise mindestens eine Schleife (12) hergestellt wird, von der ein entblößtes Ende (15) eines elektrischen Leiters (16, 16-1,...) aufgenommen werden kann, und indem
 • der das Band (1) umschließende Streifen (5) mit diesem Band (1) verbunden wird, indem die überstehenden Enden (7, 8) des Streifens (5) mit dem Teil von ihr mechanisch vereinigt werden, der auf der gegenüberliegenden Seite (6) des Bandes (1)

liegt,

– in einer darauffolgenden zweiten Phase mittels zumindest eines elektrischen Leiters (16, 16-1,...) die Streifen der·Bänder miteinander verbunden werden, indem

● ein entblößtes Ende (15) eines solchen elektrischen Leiters (16) in einer Schleife (12) des mit dem ersten Band (1) verbundenen Streifens angelegt oder angeordnet wird,

● das entblößte Ende (15) des Leiters mit dem Streifen (5) verbundenen wird,

● das andere entblößte Ende (15-1) des elektrischen Leiters (16) in einer Schleife (12) des mit dem anderen Band (1-1) verbundenen Streifens (5-1) angelegt oder angeordnet wird und indem

● das andere entblößte Ende (15-1) des Leiters mit dem Streifen (5-1) verbunden wird.

2. Verfahren nach Anspruch 1, in dem leitende Metallbänder verwendet werden, die auf ihren Flächen (9, 10) mit einer haftenden dünnen Isolierschicht (20) belegt sind, dadurch **gekennzeichnet, daß**

– die beiden haftenden dünnen Isolierschichten (20) jedes Bandes teilweise getrennt werden,

– ein leitender Streifen (5) transversal an einem Ende (3) jedes Bandes befestigt wird,

– mittels eines elektrischen Leiters (16) der Streifen des ersten Bandes mit dem Streifen des zweiten Bandes verbunden wird und

– jeder der transversalen leitenden Streifen (5) von der vom leitenden Band (1) getrennten haftenden dünnen Isolierschicht (20) abgedeckt wird.

3. Verfahren nach einem der vorhergehenden Ansprüche 1 oder 2, dadurch **gekennzeichnet, daß** Metallbänder (1, 1-1,...) verwendet werden, die ausgehend von einer Nickel- und Chromelegierung hergestellt werden.

4. Verfahren nach einem der vorhergehenden Ansprüche 1 bis 3, dadurch **gekennzeichnet, daß** dünne Isolierschichten (20) verwendet werden, die ausgehend von einem elastischen Polyimid hergestellt werden, das auf einer seiner Flächen (22) mit einem akrylartigen Klebstoff (23) überzogen ist.

5. Dünnes und elastisches leitendes Band, das auf jeder seiner Flächen (6, 9) mit einer dünnen Isolierschicht (20) überzogen ist, **gekennzeichnet** durch zumindest einen leitenden Streifen (5), der nach einem der vorhergehenden Verfahrensansprüche 1 bis 4 angeordnet und in der Lage ist, ein Ende eines elektrischen Leiters (16) aufzunehmen.

6. Leitendes Band nach Anspruch 5, dadurch **gekennzeichnet, daß** es einen Klebestreifen (25) aufweist, der von einer seiner Flächen auf eine der dünnen Isolierschichten (20) gegeben wird, und daß mehrere Öffnungen (30) die aus dem mit den dünnen Isolierschichten sowie dem Klebestreifen (25) überzogenen Metallband (1) gebildete Einheit durchziehen.

7. Vorrichtung zum Erwärmen einer Oberfläche, dadurch **gekennzeichnet, daß** sie mehrere leitende Bänder (1, 1-1, 1-2...) aufweist, die miteinander nach einem der vorhergehenden Ansprüche 1 bis 5 mittels elektrischer Leiter (16, 16-1...) verbunden sind und von einer Stromquelle (38) gespeist werden.

## Claims

1. Method for making electric connections between thin flexible conductive strips (1, 1-1,...), characterized in that :

– in a first stage, at least one conductive lamina (5, 5-1,...) is transversely fixed on each of said strips (1, 1-1,...), while

● disposing said lamina (5), the length of which is larger than the width of said strip, on one (6) of the sides of said strip (1) ;

● folding the protruding ends (7,8) of said lamina (5) onto the other side (9) of said strip, while preforming said laminae, in order to realize at least partially a loop (12) capable of receiving a bare end (15) of an electric conductor (16, 16-1,...) ; and

● making said lamina (5) enclosing the strip (1) solid with said strip (1) while mechanically connecting the protruding ends (7, 8) of said lamina (5) with the portion thereof disposed on the opposite side (6) of said strip (1) ;

– then, in a second stage, said laminae of said strips are interconnected by means of at least one electric conductor (16, 16-1,....), while

● disposing one bare end (15) of said electric conductor in a loop (12) of the lamina (5) solid with the first strip (1) ;

● making the bare end (15) of said conductor solid with said lamina (5) ;

● disposing the other bare end (15-1) of said electric conductor (16) in a loop (12) of said lamina (5-1) solid with the other strip (1-1) ; and

● making the other bare end (15-1) of said conductor solid with said lamina (5-1).

2. Method according to claim 1, wherein metallic conductive strips are used, the sides (9,10) of which are covered with an adhesive insulating film (20), characterized in that :

– said two adhesive insulating films (20) are partially separated from each of said strips ;

– one conductive lamina (5) is transversely fixed at one end (3) of each of said strips ;

– said lamina of said first strip is connected with said lamina of said second strip by means of an electric conductor (16) ;

– each of said transverse conductive laminae (5) is covered by that portion of the adhesive insulating film (20) separated from its conductive strip (1).

3. Method according to one of claims 1 or 2, characterized in that metallic strips (1, 1-1,...) made of a nickel-chrome alloy are used.

4. Method according to one of claims 1 to 3, characterized in that insulating films (20) are used which are made of a flexible polyimide coated with an adhesive (23) of the acrylic type on one of its sides (22).

5. Thin flexible conductive strip which is covered with an insulating film (20) on each of its sides (6, 9), characterized in that it comprises at least one conductive lamina (5) disposed according to any one of the method claims, said lamina being capable of receiving one end of an electric conductor (16).

6. Conductive strip according to claim 5, characterized in that it comprises an adhesive tape (25) applied by one of its sides on one of said insulating films (20) and in that a plurality of holes (30) passes through the assembly consisting of said metallic strip (1) coated with said insulating films (20) and said adhesive tape (25).

7. Device for heating a surface, characterized in that it comprises a plurality of conductive strips (1, 1-1, 1-2,...) interconnected according to any one of claims 1 to 5 by means of electric conductors (16, 16-1,...) and supplied by a power source (38).

Fig.1A

Fig.1B

Fig.1C

Fig.1D

Fig.1H

Fig.1E

Fig.1F

Fig.1G

Fig. 2

Fig.3